(19) **Europäisches Patentamt / European Patent Office / Office européen des brevets**

(11) **EP 2 293 033 A1**

(12) **EUROPEAN PATENT APPLICATION**
published in accordance with Art. 153(4) EPC

(43) Date of publication:
**09.03.2011 Bulletin 2011/10**

(21) Application number: **09762434.0**

(22) Date of filing: **05.06.2009**

(51) Int Cl.:
*G01J 3/32* (2006.01)    *G01N 21/64* (2006.01)

(86) International application number:
**PCT/JP2009/060329**

(87) International publication number:
**WO 2009/151004 (17.12.2009 Gazette 2009/51)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **09.06.2008 JP 2008150614**

(71) Applicant: **National University Corporation Toyohashi University of Technology Toyohashi-shi Aichi 441-8580 (JP)**

(72) Inventors:
- **SAWADA, Kazuaki**
  **Toyohashi-shi**
  **Aichi 441-8580 (JP)**
- **ISHII, Hiroyasu**
  **Toyohashi-shi**
  **Aichi 441-8580 (JP)**
- **MARUYAMA, Yuki**
  **Toyohashi-shi**
  **Aichi 441-8580 (JP)**

(74) Representative: **Garavelli, Paolo A.BRE.MAR. S.R.L. Via Servais 27 10146 Torino (IT)**

(54) **SPECTROSCOPIC DEVICE, AND METHOD FOR DRIVING THE DEVICE**

(57) Provided is a spectroscopic device of a new constitution, which is suited for detecting precisely a fluorescent light emitted from an inspection object in a fluorometric analysis, such as a DNA. The spectroscopic device (10) comprises a spectroscopic sensor body (21) for outputting the quantity of charge corresponding to the intensity of such a light of a spectroscopy object as corresponds to the intensity of a light having a wavelength component of a wavelength specified with the value of a gate electrode or larger, and a floating diffusion unit (51) for outputting a voltage according to the quantity of charge outputted from the spectroscopic sensor body (21). The floating diffusion unit (51) includes a plurality of serially connected charge wells (53 and 55), for which output voltages are individually detected.

Fig. 5A

Fig. 5B

**Description**

FIELD OF THE INVENTION

The present invention relates to a spectroscopic device, and a method for driving the spectroscopic device.

BACKGROUND OF THE INVENTION

A spectroscopic sensor body provided with a charge generating layer for generating a charge by an incident light, the charge generating layer having a first charge accumulating unit for accumulating a charge from a surface to a first depth in the charge generating layer, and a second charge accumulating unit for accumulating a charge from the surface to a second depth in the charge generating layer is disclosed in Patent document 1.
In the spectroscopic sensor body disclosed in the Patent document 1, an electrode film which transmits the incident light is formed on a semiconductor substrate. A gate electrode jointed to such an electrode film is applied with a gate voltage. An insulating film intervenes between the semiconductor substrate and the electrode film. In the semiconductor substrate, a diffusion layer is formed in a region facing with the electrode film. Then, if a predetermined voltage is biased to the semiconductor substrate and the gate voltage applied to the gate electrode are changed, the depth of the accumulated charge (electron) changes in the diffusion layer. On the other hand, the incident light enters into the diffusion layer to generate the charge while the incident light is absorbed into semiconductor constituting the diffusion layer and attenuates. An extent of such attenuation depends on the wavelength of the incident light.
When a light of an intensity A1 and wavelength λ 1 and a light of an intensity A2 and wavelength λ 2 are incident on simultaneously, and a charge quantity (current quantity) I1 generated from the surface to the first depth W1 in the diffusion layer (charge generating layer) and a charge quantity (current quantity) I2 generated from the surface to the second depth W2 in the diffusion layer (charge generating layer) are given, the following equation is obtained (as referred to the Patent document 1 more in detail).

$$\left\{ \begin{array}{l} I_1 = \dfrac{A_1 S q}{h v_1} (1 - e^{-\alpha_1 W_1}) + \dfrac{A_2 S q}{h v_2} (1 - e^{-\alpha_2 W_1}) \\[3mm] I_2 = \dfrac{A_1 S q}{h v_1} (1 - e^{-\alpha_1 W_2}) + \dfrac{A_2 S q}{h v_2} (1 - e^{-\alpha_2 W_2}) \end{array} \right.$$

In the equation,
$A_1$ , $A_2$ : Intensity of incident light [W/ cm$^2$]
$S$ : Sensor area [cm$^2$]
$W_1$ , $W_2$ : Accumulated positions of electron [cm]
$\alpha_1$ , $\alpha_2$ : Respective wavelength coefficients [cm$^{-1}$]
$V_1$ : Output voltage when the accumulated position of electron is $W_1$.
$V_2$ : Output voltage when the accumulated position of electron is $W_2$ .
Frequency $v_1 = c / \lambda_1$
Frequency $v_2 = c / \lambda_2$
c : Light velocity, S : Area of light receiving unit, h v: Light energy, q : Electron volt
In the equation 1, since W1 and W2 are determined by a gate voltage and I1 and I2 are detectable, both W1 and W2 and I1 and I2 are known. So, unknown intensities A1 and A2 of incident lights are obtained by solving the equation 1. Namely, the intensity A1 of the wavelength component λ. 1 and the intensity A2 of the wavelength component λ 2 of the incident lights are obtained.
Regarding the incident light which is a composite of n different wavelength components, the respective intensities A1-An of the n different wavelength components are obtained by getting the respective distances W1-Wn and charge quantities I1-In as to the n different depths in the charge generating layer.
Fluorescence analysis is known as a general method for analyzing genetic information by investigating the existence or nonexistence and the quantity of DNA or protein. In such fluorescence analysis, DNA to be inspected marked by fluorescein (fluorescence dye) is irradiated by 490 nm laser light (exciting light, input light) to detect 513 nm fluorescence emitted from the DNA marked by fluorescein.
A strong intensity of fluorescence can be emitted, However, the intensity of fluorescence is about one several hundredths of the intensity of the exciting light. So, conventionally, a filter for cutting off the exciting light is provided. Then, the exciting light is cut off by such the filter and the fluorescence passing through such the filter is detected to analyze genetic information.

Patent document 1: JP-A-No.2005-10114

DISCLOSURE OF THE INVENTION

Problems to be Solved by the invention

In fluorescence analysis, for detecting exactly whether fluorescence is generated or not, in other words, for detecting the intensity of fluorescence by extracting only fluorescence, a filter which is able to cut off an exciting light with high reliability is required. So, the filter becomes expensive.

The inventors have been investigated by using a spectroscopic device disclosed in patent document 1 to detect the intensity of fluorescence by eliminating the influence of the exciting light.

As a result, the inventors realize the following problem.

The spectroscopic device disclosed in the patent document 1 reads as a current a charge quantity outputted from an spectroscopic sensor body to analyze such a current. In this case, since an influence of a noise in a readout circuit is large, an improvement in the sensitivity of the spectroscopic sensor body is restricted.

For avoiding the influence of the noise from the circuit, a floating diffusion unit may be used. Such a floating diffusion transfers a charge to a charge well to read out a voltage of the charge well, thereby identifying a charge quantity, namely a current quantity.

In an ordinary case, the floating diffusion unit is provided with one charge well. So, when the floating diffusion unit is connected to the spectroscopic sensor body, firstly, it is thought out that the charge from the spectroscopic sensor body is transferred to such one charge well to detect the voltage of the charge well. In general, the larger the capacity of a charge well becomes, the smaller the difference in output voltage caused by the difference in a charge quantity becomes. Further, in fluorescence analysis method, since a proportion of the intensity of the exciting light to the intensity of an incident light is large, the capacity of the charge well becomes relatively large in accordance with the intensity of the exciting light.

In fluorescence analysis method, fluorescence emitted from marking material added to DNA and so forth is observed. So, it becomes important to detect the change in a charge quantity caused by fluorescence. However, a proportion of the intensity of fluorescence to the intensity of an incident light (the addition of an exciting light and the fluorescence) is small. So, in one charge well designed to have a relatively large capacity in accordance with the intensity of an exciting light, a current quantity change caused by fluorescence is outputted only as a small voltage change. As a result, it is difficult to detect a current change as a voltage change.

Means for Solving the Problems

The inventors have investigated the problems hereinbefore to conceive the present invention explained hereinafter.

Namely, a first aspect in the present invention is defined in the following.

A spectroscopic device comprising:

a spectroscopic sensor body having a charge generating layer for generating a charge by an incident light, the spectroscopic sensor body comprising a first charge accumulating unit for accumulating a charge from a surface to a first depth in the charge generating layer, and a second charge accumulating unit for accumulating a charge from the surface to a second depth in the charge generating layer; and
a floating diffusion unit for outputting an output voltage corresponding to a charge quantity of a charge accumulated by the spectroscopic sensor body, the floating diffusion unit comprising a plurality of charge wells positioned at intervals and connected in parallel to a path through which the charge flows, thereby the output voltage being detected in the charge wells respectively.

According to the spectroscopic device as defined hereinbefore, when the charge is transferred from the spectroscopic sensor body to the path, the charge is stored from an upper charge well in order among a group of charge wells which are connected to the path at an interval and in parallel. As a result, when one charge well is full up with the charge, the charge is stored into another charge well successively downward from the one charge well. Incidentally, since each capacity and a number of charge wells are set arbitrarily, even if each capacity of the charge wells is small, a large quantity of charges can be transferred from the spectroscopic sensor body by increasing a number of charge wells. Namely, a detected range is enlarged. Further, when each capacity of the charge wells is small, the large voltage difference can be outputted by the small charge quantity difference to improve a detecting sensitivity.

A second aspect in the present invention is defined in the following. Namely, a spectroscopic device in the first aspect of the present invention, a capacity of a charge well positioned on an upper stream of the path is larger than a capacity of a charge well positioned on a lower stream of the path as to the plurality of charge wells.

According to the spectroscopic device thus defined in the second aspect of the present invention, the capacity of the charge well of the upper stream which is full up with the charge is made relatively large to decrease a number of charge wells which do not contribute to the detection of the charge quantity difference, so that a constitution of the spectroscopic device is simplified. In addition, a capacity of the charge well which does not contribute to the detection of the charge quantity difference is made relatively small to improve a detection sensitivity, so that more exact detection can be attained.

A third aspect in the present invention is defined in the following. Namely, in a spectroscopic device in the first aspect or the second aspect of, a gate electrode is positioned through a transparent insulating film on a surface of the charge generating layer to control the first depth and the second depth in accordance with a voltage applied to the gate electrode.

Thus, a charge accumulating depth range (a depth from the surface) in the charge generating layer can be defined by controlling the gate voltage. Namely, by controlling the gate voltage, one charge generating layer is made to execute both functions of the first charge accumulating unit and the second charge accumulating unit. The constitution of the spectroscopic sensor device can be simplified to provide a spectroscopic device at a low price.

Incidentally, by changing a potential applied to the substrate in which the charge generating layer having a diffusion layer is formed, the charge accumulating range in the charge generating layer can be controlled.

A fourth aspect in the present invention is constituted so that the first accumulating unit and the second charge accumulating unit are separated. For example, the substrate is provided with two diffusion layers which have a different impurity concentration each other. If each of the two diffusion layers has a different impurity concentration, each charge accumulating range (the range in the direction from the surface to the depth) also differs. Thus, the first charge accumulating unit and the second charge accumulating unit are constituted.

In the spectroscopic device defined in the fourth aspect of the present invention, it is not required to apply and control the gate voltage, so that the constitution of the spectroscopic sensor body can be simplified, as compared with the spectroscopic device defined in the third aspect of the present invention.

In the first aspect in the present invention, each output voltage outputted from each charge well can be detected to attain high sensitivity in condition that a wide detecting range is maintained.

In fluorescence analysis, on condition that fluorescence from the inspected object is superposed on the exciting light, it is important to detect fluorescence. Namely, it is required to detect exactly the charge quantity change which is dependent on whether fluorescence is generated or not. However, since a proportion of fluorescence to the incident light is small, a proportion of the charge quantity change caused by fluorescence is small as compared with the total charge quantity transferred to the floating diffusion unit.

So, the charge quantity transferred to the floating diffusion unit is divided into the constant charge quantity and the changing charge quantity. Then, the constant charge quantity is stored into the first charge well and the changing charge quantity is stored into the second charge well connected the first charge well coupled in series, to extract the charge change caused by fluorescence as the charge quantity change stored into the second charge well, namely as the voltage change in the second charge well. Since the change of the light intensity caused by fluorescence is small, the capacity of the second charge well is made relatively small to improve the detecting sensitivity. Since the first charge well is always full up with the charge, it is not necessary to detect the voltage of the first charge well, so that the device constitution can be simplified.

A fifth aspect of the present invention described hereinafter is thought of from the technical knowledge described above. Namely,

a spectroscopic device comprising:

a spectroscopic sensor body applying for spectroscopy an inspected light including an exciting light transmitting through an inspected object and a fluorescence emitted from the inspected object excited by the exciting light, and having a charge generating layer which the inspected light is incident on for generating a charge, the spectroscopic sensor body comprising a first charge accumulating unit for accumulating a charge from a surface to a first depth in the charge generating layer, and a second charge accumulating unit for accumulating a charge from the surface to a second depth in the charge generating layer; and
a floating diffusion unit for outputting an output voltage corresponding to a charge quantity of a charge accumulated by the spectroscopic sensor body, the floating diffusion unit comprising a first charge well and a second charge well positioned at intervals and connected in parallel to a path through which the charge flows, the first charge well being positioned upstream to the second charge well on the path, and a capacity of the first charge well being larger than a capacity of the second charge well, whereby the first charge well is always full up with a charge generated by the inspected light so that an output voltage of the second charge well is detected.

A sixth aspect of the present invention is defined in the following. Namely, in a spectroscopic device used for fluorescence analysis defined in the fifth aspect of the present invention, a gate electrode is positioned through a transparent insulating film on a surface of the charge generating layer in the spectroscopic sensor body, and

the charge generating layer is made to function as the first charge accumulating unit by applying a first gate voltage to the gate electrode and the charge generating layer functions as the second charge accumulating unit by applying a second gate voltage to the gate electrode.

Thus, a charge accumulating depth range (a depth from the surface) in the charge generating layer can be defined by controlling the gate voltage. Namely, by controlling the gate voltage, one charge generating layer is made to execute both functions of the first charge accumulating unit and the second charge accumulating unit. The constitution of the spectroscopic sensor device can be simplified to provide a spectroscopic device at a low price.

A seventh aspect of the present invention is defined in the following. Namely, in a spectroscopic device defined in the fifth aspect of the present invention, the first accumulating unit and the second charge accumulating unit are separated in the spectroscopic sensor body, and the spectroscopic sensor body has charge generating layers of different impurity concentration.

Thus, in the spectroscopic device defined in the seventh aspect of the present invention, it is not required to apply and control the gate voltage, so that the constitution of the spectroscopic sensor body can be simplified, as compared with the spectroscopic device defined in the sixth aspect of the present invention.

An eighth aspect of the present invention is defined in the following. Namely,

a method for driving a spectroscopic device having

a spectroscopic sensor body provided with a charge generating layer for generating a charge by an incident light, the spectroscopic sensor body comprising a first charge accumulating unit for accumulating a charge from a surface to a first depth in the charge generating layer, and a second charge accumulating unit for accumulating a charge from the surface to a second depth in the charge generating layer, and

a floating diffusion unit comprising a plurality of charge wells positioned at intervals and connected in parallel to a path through which the charge flows, thereby outputting an output voltage corresponding to a charge quantity of a charge accumulated by the spectroscopic sensor body,

comprising the steps of:

transferring the charge accumulated in the first charge accumulating unit from the spectroscopic sensor body to the floating diffusion unit, identifying a charge well positioned on an uppermost stream among charge wells not full up with a charge, and storing an output voltage of the charge well positioned on uppermost stream identified as a first voltage; and

transferring the charge accumulated in the second charge accumulating unit from the spectroscopic sensor device to the floating diffusion unit, and storing an output voltage of the charge well identified as a second voltage.

When the charge is transferred from the spectroscopic sensor body to the path, the charge is stored from an upper charge well in order among a group of charge wells which are connected to the path at an interval and in parallel. As a result, when one charge well is full up with the charge, the charge is stored into another charge well successively downward from the one charge well. Incidentally, since each capacity and a number of charge wells are set arbitrarily, even if each capacity of the charge wells is small, a large quantity of charges can be transferred from the spectroscopic sensor body by increasing the number of charge wells. Namely, a detection range is enlarged. Further, when each capacity of the charge wells is small, the large voltage difference can be outputted by the small charge quantity difference to improve a detecting sensitivity.

According to the driving method defined in the eighth aspect of the present invention, the uppermost charge well which is not full up with the charge in the floating diffusion unit is identified to store the voltage of such the uppermost charge well. In other words, it is not necessary to store the data of the charge wells which are full up with the charge. So, the constitution of the spectroscopic device can be simplified to reduce the processed data quantity.

Brief DESCRIPTION OF THE DRAWINGS

FIG.1 is a diagram showing a principle of a spectroscopic sensor body.
FIG.2 is a diagram showing a characteristic of the spectroscopic sensor body.
FIG.3 is a conceptual view showing a depth which an exciting light and fluorescence enter into in a diffusion layer of the spectroscopic sensor body in fluorescent analysis.
FIG.4 is a diagram showing an output current characteristic of the spectroscopic sensor body.
FIG.5 is a diagram showing a constitution of a spectroscopic device of an embodiment.

FIG.6 is a diagram showing an equivalent circuit of a semiconductor substrate.
FIG.7 is a diagram showing a constitution of a floating diffusion unit of another embodiment.
FIG.8 is a diagram showing a constitution of a spectroscopic device of another embodiment.

DESCRIPTION OF THE REFERENCE NUMERALS

1, 21, 101 Spectroscopic sensor body
2, 22 Diffusion layer
4, 23 Insulating layer
7, 24 Gate film
8, 25 Gate electrode
10, 100 Spectroscopic device
51, 110 Floating diffusion unit
53 First charge well
55 Second charge well

EMBODIMENTS

Various features of a spectroscopic sensor body of a related art are described below. (Some features of the spectroscopic sensor body may be referred to the patent document 1 in more detail.)

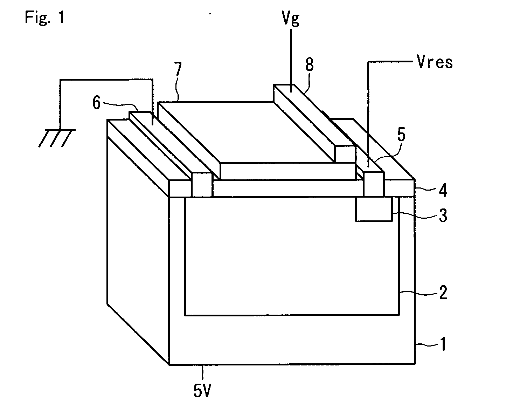

FIG.1 shows a fundamental structure of the spectroscopic sensor body 1 of the related art. The spectroscopic sensor body 1 has an electrode film 7 which transmits an incident light and is applied with gate voltage, a first diffusion layer 2 which accumulates electron generated by the incident light via an insulating film 4 beneath the electrode film 7, a second diffusion layer 3 which is formed at the one end of the first diffusion layer 2 and extracts the electron accumulated within the first diffusion layer 2, a first electrode 5 which is connected to the second diffusion layer 3 and extracts outside the electron accumulated within the first diffusion layer 2, and a second electrode 6 which is connected to the other end opposite to the second diffusion layer 3 formed in the first diffusion layer 2 and defines the potential of the first diffusion layer 2.

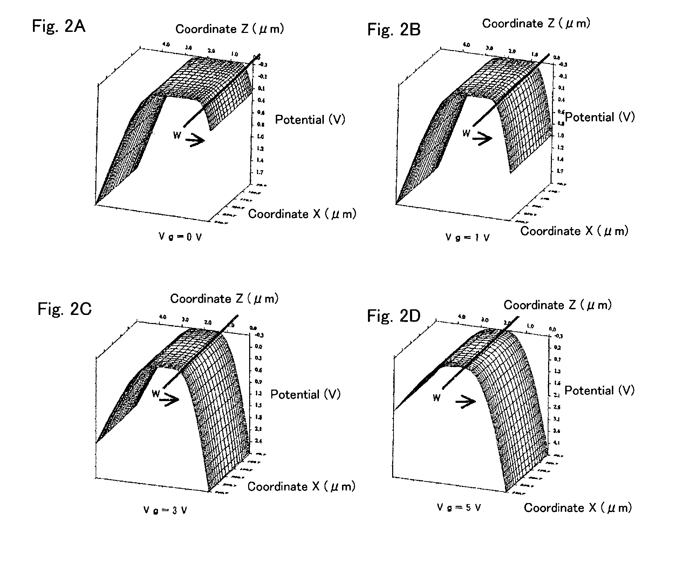

In FIG.2, perspective views A-D show the relation between the gate voltage value and the depth of an accumulated electron (z-axis). In each of the perspective views A-D, the depth of the accumulated electron is denoted by W. A charge (electron) generated between the surface of the first diffusion layer 2 and the depth W is extracted as an output.

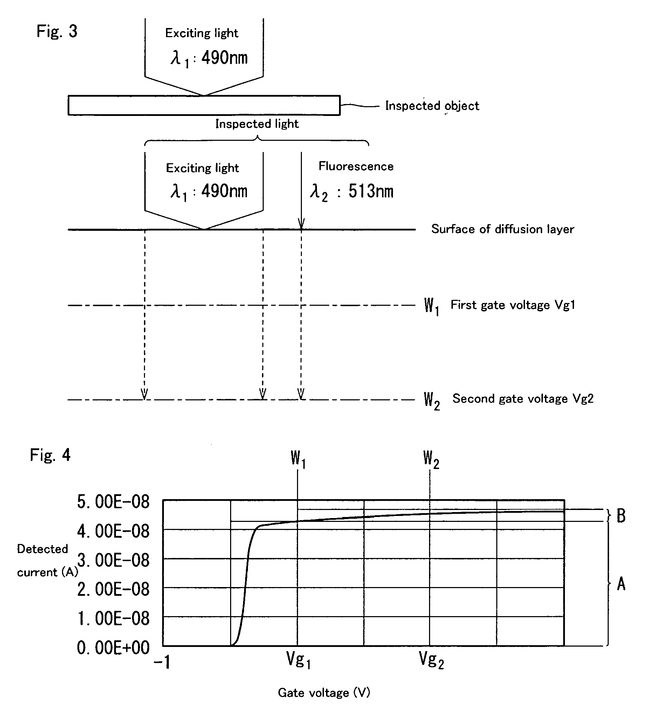

FIG.3 shows an example of inspected light which is a mixture of an exciting light of 490 nm and a fluorescent light of 513 nm.

At the beginning, a first gate voltage $Vg1$ is the gate voltage value corresponding to a depth $W1$ of the accumulated charge. Then, a second gate voltage $Vg2$ is the gate voltage value corresponding to a depth $W2$ of the accumulated charge.

In the spectroscopic sensor body 1, when the first gate voltage $Vg1$ is applied to a gate electrode 8 (the depth $W1$ of the accumulated charge), a charge caused by a light which enters from the surface into the depth $W1$ of the diffusion layer is accumulated, thereby the accumulated charge being outputted.

On the other hand, when the second gate voltage $Vg2$ is applied to the gate electrode 8 (the depth $W2$ of the accumulated charge), a charge caused by a light which enters from the surface into the depth $W2$ of the diffusion layer is accumulated, thereby the accumulated charge being outputted.

By the way, as a quantity of the fluorescent light is extremely small as compared with a quantity of the exciting light, the difference between a charge quantity $I01$(the gate voltage $Vg1$) and $I02$ (the gate voltage $Vg2$) corresponding to an incident light not including the fluorescent light and a charge quantity $I11$(the gate voltage $Vg1$) and $I12$ (the gate voltage $Vg2$) corresponding to an incident light including the fluorescent light is also a small value.

FIG.4 shows a relation between the gate voltage and the output current (charge quantity) when an incident light including the fluorescent light in addition to the exciting light is applied. Incidentally, the relation between the gate voltage and the output current when an incident light including only the exciting light is applied is overlapped with a relation between the gate voltage and the output current caused by an incident light including the fluorescent light in addition to the exciting light in a scale of FIG.4.

As referred to FIG.4, it is recognized that although an entire volume of output current (charge) is large, a variation in output current quantity is small.

In an embodiment, a large volume (part A in FIG.4) of a charge quantity outputted from a spectroscopic sensor body is stored into a first charge well. Then, a variation (part B in FIG.4) of the charge quantity outputted is stored into a second charge well. Incidentally, a capacity of the second charge well is made comparatively small to improve the detection sensitivity of the variation B of the charge quantity, so that a fluorescent light of weak intensity can be detected precisely in an exciting light of strong intensity.

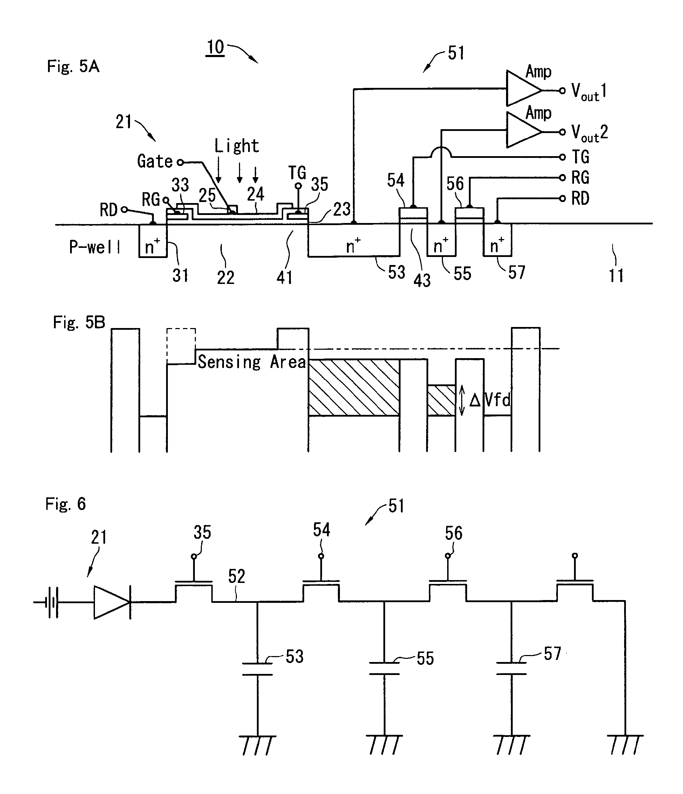

FIG.5 shows a fundamental constitution of a spectroscopic device 10 of an embodiment of the present invention. Such a spectroscopic device 10 has a constitution which combines a spectroscopic sensor body 21 and a floating diffusion unit 51.

In the spectroscopic device 10 of the embodiment, a surface of an n-type silicon semiconductor substrate is changed into p-type with a thin concentration by boron and so forth and further doped with an n-type dopant of phosphorous and so forth, to form a first charge well 53 and a second charge well 55.

A diffusion layer 22 of the spectroscopic sensor body 21 doped deeply with boron and so forth is made into p-type. A silicon oxide film (insulating film) 23 is deposited thereon. Further, a transparent and conductive gate film 24 formed of polycrystalline silicon is deposited thereon. Such the gate film 24 is provided with a gate electrode 25 which is applied with a gate voltage. Although the arranged location of the gate electrode 25 is not particularly restricted, it is preferred that the gate electrode 25 is formed on the periphery of the gate film 24.

In FIG.5, reference numeral 31 denotes a reset drain. Before detection, a potential of a reset gate 33 is set high, so that a charge existing in a charge generation unit (diffusion layer) 22 is discarded to the reset drain to initialize the charge generation unit 22.

Between the charge generation unit 22 and the first charge well 53, a first transfer gate region 41 is formed. Between the first charge well 53 and the second charge well 55, a second transfer gate region 43 is formed.

Facing with the first transfer gate region and the second transfer gate region through the insulating film, a first transfer gate electrode 35 and a second transfer gate electrode 54 are provided respectively.

FIG.6 shows an equivalent circuit constituted by elements formed in the substrate 11 shown in FIG.5. In FIG. 6, same elements as in FIG.5 are identified with same reference numerals and explanation thereof is omitted.

As shown in FIG.6, the floating diffusion unit 51 has a constitution that one conductive path 52 is connected with the first charge well 53 and the second charge well 55 in parallel and with intervening spaces in which the transfer gates 35 and 54 are disposed respectively. According to such a constitution, a charge outputted from the spectroscopic sensor body 21 is stored into the charge wells connected to the conductive path 52 in order from the upper stream charge well. A function of the conductive path 52 connected to the charge wells 53 and 55 and a reset drain 57 is carried out by the surface of the semiconductor substrate 11. So, such a function can be carried out when the respective charge wells are disposed on one imaginary line extended from the diffusion layer 22 in the semiconductor substrate 11.

When an objective inspected light is incident on the diffusion layer 22 through the gate film 24 and the insulating film 23, an electron is generated in accordance with the intensity of the objective inspected light. The depth range in which the electron is accumulated in the diffusion layer 22 is regulated by the intensity of the gate voltage applied to the gate electrode 25 (as referred to FIG.2).

The electron accumulated in the diffusion lyer 22 is transferred to the floating diffusion unit 51 when a potential of the first transfer gate electrode 35 is set high. Incidentally, the gate voltage is lower than each voltage of electrodes which constitute the floating diffusion unit 51. So, all the electrons accumulated in the diffusion layer 22 are transferred to the floating diffusion unit 51. In other word, since potential energy of the diffusion layer 22 is set higher than potential energy of the floating diffusion unit 51, all the electrons existing in the diffusion unit 22 are transferred to the floating diffusion unit 51.

Most of the electrons transferred to the floating diffusion unit 51 are stored in the first charge well 53. A potential of the second transfer gate region 43 between the first charge well 53 and the second charge well 55 is set lower than a potential of the diffusion layer 22. Accordingly, if the first charge well 53 is completely filled with electrons, electrons flowing out from the first charge well 53 fill the second charge well 55. Further, reference numeral 57 denotes the reset drain 57. With each potential of a second transfer electrode 54 and a reset gate electrode 56 set high, electrons stored in the first charge well 53 and the second charge well 55 are transferred to the reset drain 57 to evacuate the electrons from the reset drain 57 to outside.

Each of the charge wells 53 and 55 is provided with a detector which outputs a voltage in accordance with each quantity of electrons stored in the charge wells 53 and 55. For such a detector, a capacity type detector of well-known structure may be used.

By detecting each voltage, each quantity of electrons (namely, each quantity of current) transferred to the floating diffusion unit can be identified.

If the first charge well 53 is always full up with electrons, an output voltage of the first charge well is constant. So, in such a case, it may be omitted to detect the voltage of the first charge well.

Fluorescence analysis executed by using such the spectroscopic device 1 is described hereinafter.

The spectroscopic device shown in FIG.5 is provided for a unitary specimen for fluorescence analysis. An exciting light is made to transmit through the specimen without any filter to impinge on the diffusion layer 22 of the spectroscopic body 21. Then, if a fluorescent light is generated from the specimen, the fluorescent light also impinges on the diffusion layer 22. If a gate voltage applied to the gate electrode 25 is set the first gate voltage, the depth of the electron accumulated region in the diffusion layer 22 becomes W1. Therefore, the diffusion layer 22 functions as a first charge accumulating unit. An accumulated electron is transferred to the floating diffusion unit 51 and stored in the first charge well 53 and the second charge well 55 to hold each output voltage of the first charge well and the second charge well. As each output voltage corresponds to the charge quantity, I1 of the equation 1 described hereinbefore can be obtained.

Similarly, if a gate voltage applied to the gate electrode 25 is set the second gate voltage, the depth of the electron accumulated region in the diffusion layer 22 becomes W2. Therefore, the diffusion layer 22 functions as a second charge accumulating unit. An accumulated electron is transferred to the floating diffusion unit 51 and stored in the first charge well 53 and the second charge well 55 to hold each output voltage of the first charge well and the second charge well. As each output voltage corresponds to the charge quantity, I2 of the equation 1 described hereinbefore can be obtained. A depth W of the electron accumulated region in the diffusion layer 22 is determined in advance correspondingly to given gate voltage value (as referred to FIG.2). Incidentally, such a depth W can be changed in accordance with impurity concentration and so forth of the diffusion layer 22.

As described above, as parameters I1, I2, W1, and W2 of the equation 1 are determined, an intensity A1 of the exciting light and an intensity A2 of the fluorescent light can be obtained.

The equation 1 can be solved by executing software which is loaded in a general computer.

Such a general computer is provided with a CPU, a memory device, a date input device, a data output device and a bus connected to them. An output voltage of the charge well is stored into the memory device and substituted for the equation 1.

Besides, if a current quantity I1 is divided into a current quantity I1out1 corresponding to an output voltage Vout1 of the first charge well 53 and a current quantity I1out2 corresponding to an output voltage Vout2 of the second charge well 55, and if a current quantity I2 is divided into a current quantity I2out1 corresponding to an output voltage Vout1 of the first charge well 53 and a current quantity I2out2 corresponding to an output voltage Vout2 of the second charge well 55 similarly, the left side of the equation 1 is given in the following.

$$I1 = I1out1 + I1out2$$

$$I2 = I2out1 + I2out2$$

As to the given equations here, since the first charge well 53 is always full up, I1out1 and I2out1 become constant. Accordingly, the equation 1 can be solved only by charge quantity (current) I1out2 and I2out2 corresponding to an output voltage of the second charge well 55.

As described above, in condition that the intensity of the exciting light is stable and the first charge well 53 is controlled to be always full up with electrons, it can be omitted to detect the output voltage of the first charge well 53. Therefore, the constitution of the spectroscopic device can be simplified.

On the other hand, even if the intensity of the exciting light is more or less unstable, the intensity of the fluorescent light can be identified by detecting the output voltage of the first charge well 53. Accordingly, in the spectroscopic device, maintenance work can be saved.

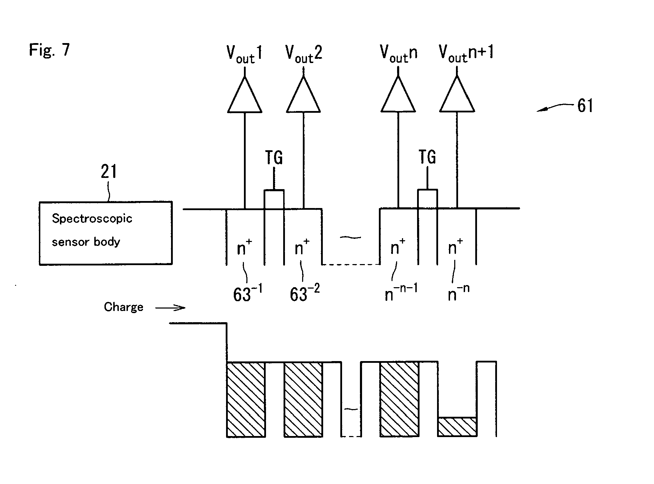

FIG.7 shows a constitution of a floating diffusion unit 61 of another embodiment. In the floating diffusion unit 61, a number of charge wells 63-1, 63-2, and so forth with a small capacity are arranged to fill all the electrons transferred from the spectroscopic sensor body into the charge wells in order from the near charge well 63-1 to the far charge well. As a result, all the charge wells from 63-1 to 63-n-1 are full up with the charge. Then, in the n-th charge well, there arises a difference in a charge quantity.

In the embodiment, the spectroscopic device provided with the number of charge wells can detect unknown intensity of the objective inspected light. In addition, since each capacity of each charge well is small, in the charge well where the difference arises, such the difference can be detected with high sensitivity.

Incidentally, it is not required that each capacity of each charge well has same the value.

It is described hereinafter how the charge well in which the difference arises is identified. Namely, in each charge well, the output voltage Vout-full when a charge is full up in the charge well and the output voltage Vout-empty when a charge is depleted in the charge well are determined in advance. After a charge is transferred from the spectroscopic sensor body 21 to the floating diffusion unit 61, each output voltage of the charge wells is investigated to obtain the following result. Namely, the charge wells from 63-1 to 63-n-1 output the voltage Vout-full which is obtained when the charge is full up. On the other hand, the charge well 63-n+1 outputs the output voltage Vout-empty when the charge is depleted. Since the output voltage Vout-63-n of the charge well 63-n has an intermediate voltage value, the charge well which outputs such an intermediate voltage value may be identified.

Such the charge well is disposed in the uppermost position of the connected stream among the charge wells which are not full up with the charge.

In the embodiment described above, with the gate voltage controlled, one diffusion layer 22 functions as both of the first charge accumulating unit and the second charge accumulating unit.

The first charge accumulating unit accumulates the charge existing from the surface to the depth W1 and the second charge accumulating unit accumulates the charge existing from the surface to the depth W2 to transfer the accumulated charge toward the floating diffusion unit respectively.

The depth in which the charge is accumulated in the diffusion layer can be controlled also by an impurity concentration doped in the diffusion layer.

The spectroscopic device 100 described hereinafter is designed on a basis of knowledge obtained above.

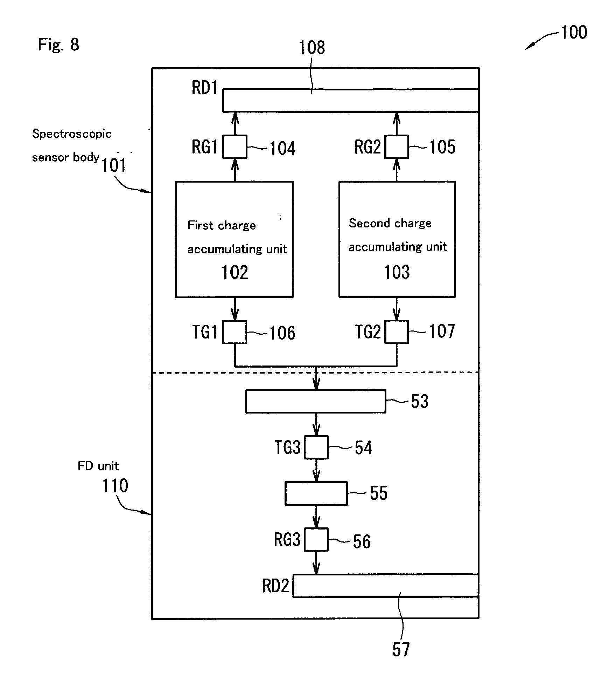

FIG.8 is a block diagram showing a constitution of a spectroscopic device 100 of another embodiment.

The spectroscopic device 100 has a spectroscopic sensor body 101 and a floating diffusion unit 110. The spectroscopic sensor body 101 has two charge accumulating units 102 and 103 which are separated from each other. A first charge accumulating unit 102 and a second charge accumulating unit 103 are formed in isolation on one semiconductor substrate, and have a same doping area, a same doping depth and different impurity concentration. Therefore, the first charge accumulating unit 102 accumulates the charge between the surface and the depth W1, and the second charge accumulating unit 103 accumulates the charge between the surface and the depth W2. Such the depth W1 and W2 are controlled and identified by a kind of impurity materials, doping quantity of impurity materials and so forth.

The charge in the first charge accumulating unit 102 and the second charge accumulating unit 103 is transferred to a floating diffusion unit 110. The charge quantity (current) transferred from the first charge accumulating unit 102 and the second charge accumulating unit 103 to the floating diffusion unit 110 can be detected.

Accordingly, the parameters W1 and W2 and the current quantities I1 and I2 in the equation 1 are identified. As a result, the intensities A1 and A2 of the lights with the different wavelengths can be obtained.

In FIG.8, reference numerals 104 and 105 denote reset gates. With such reset gates, a charge accumulated in the first charge accumulating unit 102 and the second charge accumulating unit 103 is discarded to a reset drain 108 to initialize the first charge accumulating unit 102 and the second charge accumulating unit 103.

The charge is transferred from the first charge accumulating unit 102 and the second charge accumulating unit 103 to the floating diffusion unit 110 by controlling the potential of transfer gates 106 and 107.

As to the elements constituting the floating diffusion unit 110, same elements of functioning same as the elements of FIG.5 are identified with same reference numerals and explanation thereof is omitted.

The present invention is not limited to the illustrated embodiments or examples, but may be changed or modified within the scope easily devised by those skilled in the art without departing from the spirit of the present invention.

In each embodiment, although an electron is applied as a charge, a hole may be applied as a charge by changing a conductive type of a semiconductor substrate and an impurity atom doped in the semiconductor substrate.

## Claims

1. A spectroscopic device comprising:

   a spectroscopic sensor body having a charge generating layer for generating a charge by an incident light, said spectroscopic sensor body comprising a first charge accumulating unit for accumulating a charge from a surface to a first depth in said charge generating layer, and a second charge accumulating unit for accumulating a charge from said surface to a second depth in said charge generating layer; and
   a floating diffusion unit for outputting an output voltage corresponding to a charge quantity of a charge accumulated by said spectroscopic sensor body, said floating diffusion unit comprising a plurality of charge wells positioned at intervals and connected in parallel to a path through which said charge flows, thereby said output voltage being detected in said charge wells respectively.

2. A spectroscopic device according to claim 1, wherein a capacity of a charge well positioned on an upper stream of said path is larger than a capacity of a charge well positioned on a lower stream of said path as to said plurality of charge wells.

3. A spectroscopic device according to claim 1 or 2, wherein a gate electrode is positioned through a transparent insulating film on a surface of said charge generating layer in said spectroscopic sensor body, and
   said charge generating layer is made to function as said first charge accumulating unit by applying a first gate voltage to said gate electrode and said charge generating layer is made to function as said second charge accumulating unit by applying a second gate voltage to said gate electrode.

4. A spectroscopic device according to claim 1 or 2, wherein said first accumulating unit and said second charge accumulating unit are separated in said spectroscopic sensor body, and

said spectroscopic sensor body has charge generating layers of different impurity concentration.

5. A spectroscopic device comprising:

a spectroscopic sensor body applying for spectroscopy an inspected light including an exciting light transmitting through an inspected object and a fluorescence emitted from said inspected object excited by said exciting light, and having a charge generating layer which said inspected light is incident on for generating a charge, said spectroscopic sensor body comprising a first charge accumulating unit for accumulating a charge from a surface to a first depth in said charge generating layer, and a second charge accumulating unit for accumulating a charge from said surface to a second depth in said charge generating layer; and

a floating diffusion unit for outputting an output voltage corresponding to a charge quantity of a charge accumulated by said spectroscopic sensor body, said floating diffusion unit comprising a first charge well and a second charge well positioned at intervals and connected in parallel to a path through which said charge flows, said first charge well being positioned upstream to said second charge well on said path, and a capacity of said first charge well being larger than a capacity of said second charge well, whereby said first charge well is always full up with a charge generated by said inspected light so that an output voltage of said second charge well is detected.

6. A spectroscopic device according to claim 5, wherein a gate electrode is positioned through a transparent insulating film on a surface of said charge generating layer in said spectroscopic sensor body, and

said charge generating layer is made to function as said first charge accumulating unit by applying a first gate voltage to said gate electrode and said charge generating layer is made to function as said second charge accumulating unit by applying a second gate voltage to said gate electrode.

7. A spectroscopic device according to claim 5, wherein said first accumulating unit and said second charge accumulating unit are separated in said spectroscopic sensor body, and

said spectroscopic sensor body has charge generating layers of different impurity concentration.

8. A method for driving a spectroscopic device having

a spectroscopic sensor body provided with a charge generating layer for generating a charge by an incident light, said spectroscopic sensor body comprising a first charge accumulating unit for accumulating a charge from a surface to a first depth in said charge generating layer, and a second charge accumulating unit for accumulating a charge from said surface to a second depth in said charge generating layer, and

a floating diffusion unit comprising a plurality of charge wells positioned at intervals and connected in parallel to a path through which said charge flows, thereby outputting an output voltage corresponding to a charge quantity of a charge accumulated by said spectroscopic sensor body, comprising the steps of:

transferring said charge accumulated in said first charge accumulating unit from said spectroscopic sensor body to said path, identifying a charge well positioned on an uppermost stream among charge wells not full up with a charge, and storing an output voltage of said charge well positioned on uppermost stream identified as a first voltage; and

transferring said charge accumulated in said second charge accumulating unit from said spectroscopic sensor device to said path, and storing an output voltage of said charge well identified as a second voltage.

9. A spectroscopic device comprising:

a spectroscopic sensor body provided with a charge generating layer for generating a charge by an incident light; and

a floating diffusion unit for outputting an output voltage corresponding to a charge quantity of a charge accumulated by said spectroscopic sensor body,

wherein said spectroscopic sensor body and said floating diffusion unit are formed on a surface of a semiconductor substrate, with said charge generating layer doped with an impurity of a first conductive type, and a first charge well and a second charge well doped with an impurity of a second conductive type and constituting said floating diffusion unit, and

said charge generating layer, said first charge well and said second charge well intervened with a first transfer gate region and a second transfer gate region respectively are formed on a same imaginary line, and

a gate electrode is arranged through a transparent insulating film on a surface of said charge generating layer, with a voltage detector connected respectively to said first charge well and said second charge well, and a first transfer gate electrode and a second transfer gate electrode arranged respectively through an insulating film on said first transfer gate region and said second transfer gate region.

Fig. 1

Vg

Vres

5V

Fig. 2A

Coordinate Z ($\mu$m)

Potential (V)

Coordinate X ($\mu$m)

V g = 0 V

Fig. 2B

Coordinate Z ($\mu$m)

Potential (V)

Coordinate X ($\mu$m)

V g = 1 V

Fig. 2C

Coordinate Z ($\mu$m)

Potential (V)

Coordinate X ($\mu$m)

V g = 3 V

Fig. 2D

Coordinate Z ($\mu$m)

Potential (V)

Coordinate X ($\mu$m)

V g = 5 V

Fig. 3

Exciting light
$\lambda_1$: 490nm

— Inspected object

Inspected light

Exciting light
$\lambda_1$: 490nm

Fluorescence
$\lambda_2$: 513nm

Surface of diffusion layer

$W_1$  First gate voltage Vg1

$W_2$  Second gate voltage Vg2

Fig. 4

| | $W_1$ | | $W_2$ | | |
| --- | --- | --- | --- | --- | --- |

Detected current (A)

5.00E−08
4.00E−08
3.00E−08
2.00E−08
1.00E−08
0.00E+00

−1     $Vg_1$     $Vg_2$

B

A

Gate voltage (V)

Fig. 5A

Fig. 5B

Fig. 6

Fig. 7

$V_{out}1$   $V_{out}2$   $V_{out}n$   $V_{out}n+1$

61

TG   TG

21

Spectroscopic
sensor body

$n^+$   $n^+$   $n^+$   $n^+$

$63^{-1}$   $63^{-2}$   $n^{-n-1}$   $n^{-n}$

Charge →

Fig. 8

<table>
<tr><td colspan="2" align="center">**INTERNATIONAL SEARCH REPORT**</td><td colspan="2">International application No.<br>PCT/JP2009/060329</td></tr>
</table>

| A. CLASSIFICATION OF SUBJECT MATTER |
|---|
| _G01J3/32_(2006.01)i, _G01N21/64_(2006.01)i |

According to International Patent Classification (IPC) or to both national classification and IPC

| B. FIELDS SEARCHED |
|---|
| Minimum documentation searched (classification system followed by classification symbols)<br>G01J3/00-G01J3/52, H04N5/335 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
    WPI

| C. DOCUMENTS CONSIDERED TO BE RELEVANT | | |
|---|---|---|
| Category* | Citation of document, with indication, where appropriate, of the relevant passages | Relevant to claim No. |
| Y | JP 10-012858 A  (Fujitsu Ltd.),<br>16 January, 1998 (16.01.98),<br>Par. Nos. [0001] to [0006], [0010], [0018],<br>[0022]; Figs. 1, 11 | 1-9 |
| Y | JP 2005-010114 A  (Japan Science and Technology<br>Agency),<br>13 January, 2005 (13.01.05),<br>Par. Nos. [0005] to [0006], [0039] to [0042],<br>[0057] | 1-9 |
| Y | JP 61-049463 A  (Matsushita Electronics Corp.),<br>11 March, 1986 (11.03.86),<br>Page 2, lower left column, lines 12 to 20;<br>page 2, lower right column, line 2 to 9, 17 to<br>19; page 3, upper left column, lines 10 to 15;<br>Figs. 3 to 4, 6 | 9 |

☒  Further documents are listed in the continuation of Box C.       ☒  See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    17 June, 2009 (17.06.09) | Date of mailing of the international search report<br>    30 June, 2009 (30.06.09) |
|---|---|
| Name and mailing address of the ISA/<br>    Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/060329

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 2002-513145 A (Foveon, Inc.),<br>08 May, 2002 (08.05.02),<br>Fig. 6 | 4 |

Form PCT/ISA/210 (continuation of second sheet) (April 2007)

| INTERNATIONAL SEARCH REPORT<br>Information on patent family members | International application No.<br>PCT/JP2009/060329 |
|---|---|

```
JP 10-012858 A        1998.01.16      (Family: none)

JP 2005-010114 A      2005.01.13      CN  1809732 A          2006.07.26
                                      EP  1645855 A1         2006.04.12
                                      JP  4073831 B2         2008.04.09
                                      KR  20060023573 A      2006.03.14
                                      US  2006/244089 A1     2006.11.02
                                      US  7465915 B2         2008.12.16
                                      WO  2004/113854 A1     2004.12.29

JP 61-049463 A        1986.03.11      (Family: none)

JP 2002-513145 A      2002.05.08      CN  1298483 A          2001.06.06
                                      CN  100416241 C        2008.09.03
                                      EP  1078233 A1         2001.02.28
                                      EP  1078233 A4         2001.08.08
                                      EP  1171918 A1         2002.01.16
                                      TW  407428 B           2000.10.01
                                      TW  448683 B           2001.08.01
                                      US  5965875 A          1999.10.12
                                      US  6606120 B1         2003.08.12
                                      US  2003/169359 A1     2003.09.11
                                      WO  00/05874 A1         2000.02.03
                                      WO  00/62350 A1         2000.10.19
                                      WO  99/56097 A1         1999.11.04
```

Form PCT/ISA/210 (patent family annex) (April 2007)

21

**EP 2 293 033 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005010114 A